# EUROPÄISCHE PATENTSCHRIFT

(11) **EP 2 976 152 B1**
(45) Veröffentlichungstag und Bekanntmachung des Hinweises auf die Patenterteilung: **18.10.2017**
(21) Anmeldenummer: 14706636.9
(22) Anmeldetag: 26.02.2014
(51) Int. Cl.: B01J 15/00, C01B 33/035, H01J 37/32, B01J 19/00, B01J 19/08, C23C 16/24

(54) **VORRICHTUNG ZUM SCHUTZ EINER ELEKTRODENDICHTUNG IN EINEM REAKTOR ZUR ABSCHEIDUNG VON POLYKRISTALLINEM SILICIUM**
DEVICE FOR PROTECTING AN ELECTRODE SEAL IN A REACTOR FOR THE DEPOSITION OF POLYCRYSTALLINE SILICON
DISPOSITIF SERVANT À PROTÉGER UN JOINT D'ÉTANCHÉITÉ POUR ÉLECTRODE DANS UN RÉACTEUR SERVANT À DÉPOSER DU SILICIUM POLYCRISTALLIN

(30) Priorität: 20.03.2013 DE 102013204926
(43) Veröffentlichungstag der Anmeldung: 27.01.2016
(73) Patentinhaber: Wacker Chemie AG, 81737 München (DE)
(72) Erfinder: KRAUS, Heinz, 84367 Zeilarn (DE); HEGEN, Andreas, 84533 Marktl (DE); KUTZA, Christian, 84489 Burghausen (DE)
(74) Vertreter: Potten, Holger
(86) Internationale Anmeldenummer: PCT/EP2014/053736
(87) Internationale Veröffentlichungsnummer: WO 2014/146877

(56) Entgegenhaltungen:
- EP-A2- 2 544 215
- DE-A1-102010 000 270
- DE-A1-102010 013 043

## Beschreibung

Die Erfindung betrifft eine Vorrichtung zum Schutz einer Elektrodendichtung in einem Reaktor zur Abscheidung von polykristallinem Silicium.

Hochreines Silicium wird in der Regel mittels des Siemens-Verfahrens hergestellt. Dabei wird ein Reaktionsgas enthaltend Wasserstoff und eine oder mehrere siliciumhaltige Komponenten in den Reaktor mit den durch den direkten Stromdurchgang erhitzen Trägerkörpern eingeleitet, an denen sich Si in fester Form abscheidet. Als Silicium enthaltende Verbindungen werden bevorzugt Silan (SiH₄), Monochlorsilan (SiH₃Cl), Dichlorsilan (SiH₂Cl₂), Trichlorsilan (SiHCl₃), Tetrachlorsilan (SiCl₄) bzw. deren Mischungen eingesetzt.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden über die der Anschluss an die Elektrodenhalterung und Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschten Durchmesser erreicht ist, wird der Prozess beendet.

Die Siliciumstäbe werden im CVD Reaktor von speziellen Elektroden gehalten, die in der Regel aus Graphit bestehen. Jeweils zwei Filamentstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt. Dabei wächst der Durchmesser der Dünnstäbe. Gleichzeitig wächst die Elektrode, beginnend an ihrer Spitze, in den Stabfuß der Siliciumstäbe ein. Nach dem Erreichen eines gewünschten Solldurchmessers der Siliciumstäbe wird der Abscheideprozess beendet, die Siliciumstäbe abgekühlt und ausgebaut.

Eine besondere Bedeutung kommt hier dem Schutz der durch die Bodenplatte geführten Elektrodenhalterung zu. Zu diesem Zweck ist der Einsatz von Elektrodendichtungsschutzkörpern vorgeschlagen worden, wobei insbesondere der Anordnung und der Form der Elektrodendichtungsschutzkörper sowie dem verwendeten Material Bedeutung zukommt.

Zwischen dem in die Abscheideanlage hinein ragenden Kopf der Elektrodenhalterung und der Bodenplatte befindet sich ein ringförmiger Körper. Dieser hat zwei Funktionen: eine Abdichtung der Durchführung der Elektrodenhalterung und eine elektrische Isolation der Elektrodenhalterung zur Bodenplatte hin.

Aufgrund der hohen Gasraumtemperatur im CVD-Reaktor ist ein thermischer Schutz des Dichtkörpers notwendig. Ungenügende thermische Schutzwirkung bedeutet vorzeitiger Verschleiß der Dichtkörper durch Verschmoren der Dichtkörper, thermisch bedingtes Fliessen des Dichtkörpers, Undichtigkeit des Reaktors, Unterschreiten des Mindestabstands zwischen Elektrodenhalterung und Bodenplatte und Erdschluss an verkohlten Dichtkörpern. Erdschluss oder Undichtigkeiten haben einen Ausfall der Abscheideanlage und damit einen Abbruch des Abscheideprozesses zur Folge. Dies verursacht eine verminderte Ausbeute und höhere Kosten.

Daher sind Schutzkörper vorgeschlagen worden, um die Dichtungen zu schützen.

Aus US 20110305604 A1 ist bekannt, die Dichtungen der Elektroden mittels Schutzringen aus Quarz gegen thermische Belastung abzuschirmen. Der Reaktorboden weist eine spezielle Ausgestaltung auf. Der Reaktorboden umfasst einen ersten Bereich und einen zweiten Bereich. Der erste Bereich ist durch eine dem Innenraum des Reaktors zugewandte Platte und einer Zwischenplatte, die die Düsen trägt, gebildet. Der zweite Bereich des Reaktorbodens ist durch die Zwischenplatte und eine Bodenplatte, die die Versorgungsanschlüsse für die Filamente trägt, gebildet. In den so gebildeten ersten Bereich wird das Kühlwasser geführt, um somit den Reaktorboden zu kühlen. Die Filamente selbst sitzen in einem Grafitadapter. Dieser Grafitadapter greift in einen Grafitspannring ein, der selbst über einen Quarzring mit der Platte zusammenwirkt. Die Kühlwasseranschlüsse für die Filamente können in Form von Schnellkupplungen ausgebildet sein.

WO 2011116990 A1 beschreibt eine Elektrodenhalterung mit einem Quarzabdeckring. Die Prozesskammereinheit besteht aus einer Kontakt- und Spanneinheit, einem Grundelement, einer Quarzabdeckscheibe und einem Quarzabdeckring. Die Kontakt- und Spanneinheit besteht aus mehreren, relativ zueinander bewegbaren Kontaktelementen, die einen Aufnahmeraum für einen Silizium-Dünnstab bilden. Die Kontakt- und Spanneinheit ist in einen entsprechenden Aufnahmeraum des Grundelements einführbar, wobei sich bei der Einführung in das Grundelement der Aufnahmeraum für den Silizium-Dünnstab verengt, und dieser dadurch sicher eingespannt und elektrisch kontaktiert wird. Das Grundelement besitzt auch eine untere Aufnahme zum Aufnehmen einer Kontaktspitze der Durchführeinheit. Die Quarzabdeckscheibe besitzt Mittelöffnungen zur Durchführung der Kontaktspitze der Durchführeinheit. Der Quarzabdeckring ist derart bemessen, dass er einen innerhalb einer Prozesskammer eines CVD-Reaktors liegenden Bereich der Durchführeinheit wenigstens teilweise radial umgeben kann.

Da Quarz eine niedrige Wärmeleitfähigkeit besitzt, werden allerdings diese Bauteile bei Abscheidebedingungen so heiß, dass auf ihrer Oberfläche eine dünne Siliciumschicht mit hoher Temperatur aufwächst. Bei diesen Bedingungen ist die Siliciumschicht elektrisch leitend, was zu einem Erdschluss führt.

WO 2011092276 A1 beschreibt eine Elektrodenhalterung, bei der das Dichtelement zwischen Elektrodenhalterung und Bodenplatte durch einen umlaufenden Keramikring vor Temperatureinflüssen geschützt wird. Mehrere Elektroden sind in einem Boden des Reaktors befestigt. Die Elektroden tragen dabei Filamentstäbe, die in einem Elektrodenkörper sitzen und über den die Stromzufuhr zu den Elektroden bzw. Filamentstäben erfolgt. Der Elektrodenkörper selbst ist mit mehreren elastischen Elementen in Richtung der Oberseite des Bodens des Reaktors hin mechanisch vorgespannt. Zwischen der Oberseite des Bodens des Reaktors und einem zur Oberseite des Bodens parallelen Ring des Elektrodenkörpers ist ein radial umlaufendes Dichtelement eingesetzt. Das Dichtelement selbst ist im Bereich zwischen der Oberseite des Bodens des Reaktors und dem dazu parallelen Ring des Elektrodenkörpers von einem Keramikring abgeschirmt.

US 20130011581 A1 offenbart eine Vorrichtung zum Schutz von Elektrodenhalterungen in CVD Reaktoren, umfassend eine zur Aufnahme eines Filamentstabs geeigneten Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektroden angeordneten Schutzkörper geschützt wird, wobei der Schutzkörper in Richtung der Elektrodenhalterung zumindest abschnittsweise in seiner Höhe zunimmt. Dabei sind geometrische Körper in konzentrischer Anordnung um die Elektrodenhalterung vorgesehen, deren Höhe mit zunehmendem Abstand von der Elektrodenhalterung abnimmt. Es kann sich auch um einen einteiligen Körper handeln. Dies dient dem thermischen Schutz des Dichtungs- und Isolierungskörpers der Elektrodenhalterung sowie einer Strömungsmodifikation am Stabfuß der abgeschiedenen Polysilicium-Stäbe, die die Umfallquote positiv beeinflusst.

Bei den Vorrichtungen nach WO 2011092276 A1 und US 20130011581 A1 kann es trotz thermischen Schutzes der Dichtung zwischen Elektrodenhalterung und Bodenplatte zu einem Erdschluss kommen.

Kurzschlüsse bedeuten ein abruptes Prozessende durch Ausfall der Stromversorgung zur Beheizung der Stäbe. Die Stäbe können nicht bis zum vorgesehenen Enddurchmesser gefahren werden. Mit dünneren Stäben fällt die Anlagenkapazität niedriger aus, was erhebliche Kosten verursacht.

Aus dieser Problematik ergab sich die Aufgabenstellung der Erfindung, nämlich einen wirkungsvollen Schutz vor Erdschlüsse und eine thermische Abschirmung des Dichtkörpers zu ermöglichen.

Die Aufgabe wird gelöst durch eine Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist, und wobei ein radial die Elektrodenhalterung (1) und den Dichtkörper (2) umlaufender Schutzring (4), der die Bodenplatte berührt, und eine Abdeckkappe (7), die auf der Elektrodenhalterung (1) aufliegt, jedoch nicht die Bodenplatte (3) berührt, wobei die Abdeckkappe (7) über dem Schutzring (4) angeordnet ist, diesen jedoch nicht berührt.

Vorzugsweise umfasst die Abdeckkappe (7) einen in Richtung Bodenplatte (3) heruntergezogenen Rand, so dass Abdeckkappe (7) und Schutzring (4) in vertikaler Richtung überlappen.

Vorzugsweise beträgt ein Abstand zwischen Abdeckkappe (7) und Schutzring (4) von 3 bis 40 mm.

Vorzugsweise beträgt ein Abstand zwischen Abdeckkappe (7) und Bodenplatte (3) mehr als 5 mm.

Die Aufgabe wird ferner gelöst durch eine Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist, und wobei ein radial die Elektrodenhalterung (1) und den Dichtkörper (2) umlaufender Schutzring (4), der die Bodenplatte berührt, und eine Abdeckung (6), die die Elektrodenhalterung (1) seitlich und von oben berührt, wobei kein Kontakt zwischen Abdeckung (6) und Bodenplatte (3) besteht, wobei der Schutzring (4) gegen die Abdeckung (6) seitlich versetzt ist, wobei der Schutzring (4) eine seitliche Lücke zwischen Abdeckung (6) und Bodenplatte (3) schließt, vorgesehen sind.

Vorzugsweise ist die Abdeckung im radialen Querschnitt L-förmig.

Ebenso ist es bevorzugt, wenn die Abdeckung (6) in vertikaler Richtung beweglich ist und Schutzring (4) und Abdeckung (6) aus einem elektrischen isolierenden Material mit einem spezifischen elektrischen Widerstand von größer als 10⁹ Ωcm, bevorzugt größer als 10¹¹ Ωcm bei Raumtemperatur bestehen. Die Abdeckung (6) hat eine spezifische Wärmeleitfähigkeit bei Raumtemperatur von größer als 10 W/mK, vorzugsweise von größer als 20 W/mK.

Die Aufgabe wird ferner gelöst durch eine Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist, und wobei ein radial die Elektrodenhalterung (1) und den Dichtkörper (2) umlaufender Schutzring (4), der die Bodenplatte berührt, und eine radial die Elektrodenhalterung (1) und den Dichtkörper (2) umlaufende Abdeckung (6), die die Elektrodenhalterung (1) und die Bodenplatte (3) berührt, vorgesehen sind, wobei die Abdeckung (6) die Elektrodenhalterung sowohl seitlich als auch von oben berührt und die Abdeckung (6) aus einem elektrischen isolierenden Material mit einem spezifischen elektrischen Widerstand von größer als 10⁹ Ωcm bei Raumtemperatur besteht, das zugleich eine Wärmeleitfähigkeit von größer als 10 W/mK, vorzugsweise von größer als 20 W/mK, bei Raumtemperatur aufweist.

Die Aufgabe wird ferner gelöst durch eine Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist, und wobei ein radial die Elektrodenhalterung (1) und den Dichtkörper (2) umlaufender Schutzring (4), der die Bodenplatte berührt, und den Schutzring (4) und die Elektrodenhalterung (1) radial umlaufende Ringsegmente (8) vorgesehen sind, wobei der Schutzring (4) weiter von der Elektrodenhalterung (1) beabstandet ist als die Ringsegmente (8), und wobei sowohl Schutzring (4) als auch Ringsegmente (8) aus einem elektrischen isolierenden Material mit einem spezifischen elektrischen Widerstand von größer als 10⁹ Ωcm, vorzugsweise von größer als 10¹¹ Ωcm, bei Raumtemperatur bestehen, das zugleich eine spezifische Wärmeleitfähigkeit von größer als 1 W/mK bei Raumtemperatur aufweist.

Bei der erfindungsgemäßen Vorrichtung und den nachfolgend erläuterten Ausführungsformen sind die vorgesehen Schutzringe / Abdeckungen so ausgestaltet, dass wenigstens der Teil der Bodenplatte zwischen Elektrodenhalterung bzw. Dichtkörper und Schutzkörper / Abdeckung nach oben hin geschützt ist. Dadurch wird verhindert, dass Siliciumsplitter zwischen Schutzring und Elektrodenhalterung fallen und die elektrische Isolierung der Elektrodenhalterung zur Bodenplatte hin überbrücken können. Dies war eine Ursache für im Stand der Technik beobachtete Erdschlüsse.

Beschrieben ist ferner eine Vorrichtung, die einen Schutzring (4) in Verbindung mit einer Abdeckscheibe (5) vorsieht, wobei die Abdeckscheibe auf der Elektrodenhalterung (1) aufliegt, wobei keine Berührung zwischen Schutzring (4) und Abdeckscheibe (5) besteht, wobei die Abdeckscheibe (5) den Schutzring (4) von oben her schützt, wobei zwischen Schutzring (4) und Abdeckscheibe (5) ein Abstand von wenigstens 5 mm besteht.

Vorzugsweise ist bei der Vorrichtung ein Schutzring (4) in Verbindung mit einer Abdeckscheibe (5) vorgesehen, wobei die Abdeckscheibe (5) auf dem Schutzring (4) aufliegt, wobei die Abdeckscheibe (5) die Elektrodenhalterung (1) nicht berührt, und entweder die Abdeckscheibe (5) oder der Schutzring (4) aus elektrisch isolierendem Material mit einem spezifischen elektrischen Widerstand bei Raumtemperatur von größer als 10⁹ Ωcm, vorzugsweise größer 10¹¹ Ωcm bestehen und dieses zugleich eine spezifische Wärmeleitfähigkeit bei Raumtemperatur von größer als 10 W/mK, vorzugsweise größer als 20 W/mK aufweist.

Beschrieben ist ferner eine Vorrichtung, die keinen Schutzring (4), sondern nur eine Abdeckung (6) umfasst, wobei die Abdeckung (6) sowohl die Bodenplatte (3) als auch die Elektrodenhalterung (1) berührt, wobei die Abdeckung (6) die Elektrodenhalterung sowohl seitlich als auch von oben berührt und die Abdeckung (6) aus einem elektrischen isolierenden Material mit einem spezifischen elektrischen Widerstand bei Raumtemperatur von größer als 10⁹ Ωcm, vorzugsweise größer als 10¹¹ Ωcm besteht, das zugleich eine Wärmeleitfähigkeit bei Raumtemperatur von größer als 10 W/mK, vorzugsweise von größer 20 W/mK aufweist. Vorzugsweise ist die Abdeckung im radialen Querschnitt L-förmig.

Vorzugsweise umfasst die Vorrichtung einen Schutzring (4) und eine Abdeckkappe (7), wobei die Abdeckkappe (7) die Elektrodenhalterung (1) seitlich und oder oben (oben nicht in der Abbildung dargestellt) berührt, jedoch nicht die Bodenplatte (3) berührt, wobei die Abdeckkappe (7) über dem Schutzring (4) angeordnet ist, diesen jedoch nicht berührt.

Die Erfindung betrifft auch ein Verfahren zur Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer der zuvor genannten Vorrichtungen befindet, der mittels der Elektrode mit Strom versorgt und der damit durch direkten Stromdurchgang auf eine Temperatur aufgeheizt wird, bei der sich Silicium am Filamentstab abscheidet.

Die erfindungsgemäße Vorrichtung und deren Ausführungsformen, die nachfolgend im Detail beschrieben werden, sehen unterschiedliche Formen von Elektrodenabdeckungen vor, die so gefertigt sind, dass der Dichtkörper von Wärmeströmung und Wärmestrahlung abgeschirmt wird. Bei hohem Feeddurchsatz und großem Stabdurchmesser werden die Dichtkörper besonders stark thermisch belastet. Bei diesen Bedingungen kommt dem Wärmeschutz der Elektrodenabdeckung eine besonders große Bedeutung zu.

Die Elektrodenabdeckungen haben somit zwei Funktionen:
- Abkapselung der Elektrodenhalterung im Bereich des Dichtkörpers zur Bodenplatte vom Reaktorraum, so dass keine Brückung des Dichtkörpers von Elektrodenhalterung zur Bodenplatte durch Siliciumsplitter möglich ist;
- Reduzierung der Temperaturbelastung des Dichtkörpers durch verbesserten thermischen Schutz.

Es sind mehrere Ausführungsformen von Elektrodenabdeckungen möglich, nämlich Schutzringe, Abdeckscheiben, im radialen Querschnitt L-förmige Abdeckungen, Abdeckkappen und Ringsegmente. Sie können einen ein- oder mehrteiligen Aufbau haben.

An deren Materialeigenschaften sind hohe Anforderungen gestellt. Sie müssen bei den hohen Gasraumtemperaturen sowohl thermisch als auch chemisch in einer Halogensilan / HCl / H₂-Atmosphäre beständig sein.

Je nach Ausführungsform ist auch eine Unterscheidung zwischen elektrischen Leitern und Nichtleitern, mit niedriger und hoher spezifischer Wärmeleitfähigkeit notwendig, wie in der detaillierten Beschreibung der bevorzugten Ausführungsformen gezeigt wird.

Zur Erhöhung der Wärmeableitung von Schutzkörpern zur gekühlten Elektrodenhalterung kann die Abdeckkappe oder ein an die Elektrodenhalterung anliegender Schutzring fest mit der Elektrodenhalterung lösbar verbunden werden, z.B. mit einer Schraubverbindung. In diesem Fall hat die Elektrodenhalterung ein Außen-(gewinde), Abdeckkappe oder Schutzring ein Innengewinde.

Im Folgenden werden die bevorzugten Ausführungsformen erläutert.

Dabei wird auch auf die **Figuren 1-7** Bezug genommen.

### Kurzbeschreibung der Figuren

**Fig. 1** zeigt eine Vorrichtung gemäß Stand der Technik mit umlaufendem, die Elektrodenhalterung nicht berührenden Schutzring.
**Fig. 2** zeigt eine Ausführung mit Schutzring und Abdeckscheibe.
**Fig. 3a** zeigt eine Ausführung mit im radialen Querschnitt L-förmiger Abdeckung und ohne Schutzring.
**Fig. 3b** zeigt eine Ausführung mit im radialen Querschnitt L-förmiger Abdeckung und mit Schutzring.
**Fig. 4** zeigt eine Ausführung mit Schutzring, der die Elektrodenhalterung seitlich berührt.
**Fig. 5** zeigt eine Ausführung mit Schutzring und Abdeckkappe.
**Fig. 6** zeigt eine Ausführung mit Schutzring und Ringsegmenten.
**Fig. 7** zeigt eine Ausführung mit Schutzring und aufliegender Abdeckscheibe.
**Fig. 8** zeigt eine Ausführung mit vertikal verschiebbarer Abdeckung und Schutzring.

### Liste der verwendeten Bezugszeichen

- **1**: Elektrodenhalterung
- **2**: Dichtkörper
- **3**: Bodenplatte
- **4**: Schutzring
- **5**: Abdeckscheibe
- **6**: Abdeckung
- **7**: Abdeckkappe
- **8**: Ringsegmente

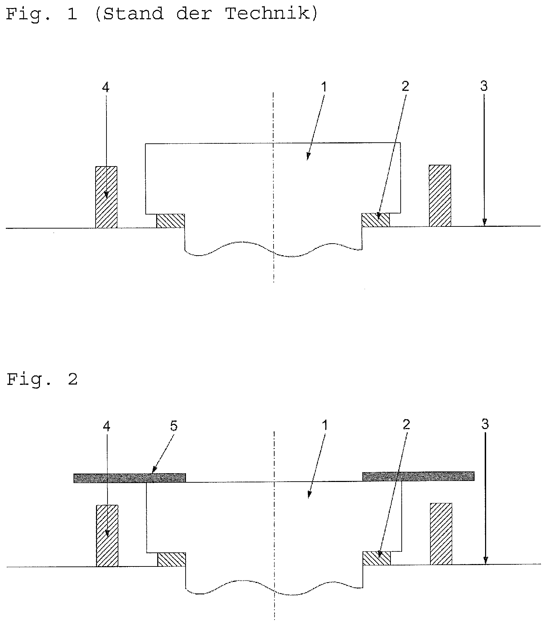

**Fig. 1** zeigt eine Ausführung gemäß Stand der Technik. Auf der Bodenplatte **3** eines Reaktors ist eine Elektrodenhalterung **1** angebracht. Zwischen Bodenplatte **3** und dem Kopf der Elektrodenhalterung **1** ist ein Dichtkörper **2** angeordnet. Zum Schutz des Dichtkörpers **2** ist ein umlaufender Schutzring **4** vorgesehen.

### Erste bevorzugte Ausführungsform

**Fig. 2** zeigt schematisch eine erste bevorzugte Ausführungsform.

Es ist mindestens ein Schutzring **4** auf der Bodenplatte **3** in Kombination mit einer Abdeckscheibe **5** auf der Elektrodenhalterung **1** vorgesehen.

Der Schutzring **4** umgibt den Dichtkörper **2** radial umlaufend.

Abdeckscheibe **5** und Schutzring **4** sind durch einen umlaufenden Spalt getrennt. Der Spaltabstand sollte mindestens so groß bemessen sein, dass bei der max. anliegenden Spannung kein Überschlag von Abdeckscheibe zum Schutzring auftritt. Bevorzugt ist ein Spaltabstand von größer als 5 mm. Dadurch ist weder ein elektrischer Kontakt noch ein elektrischer Überschlag zur Bodenplatte **3** möglich.

Der Schutzring **4** hat einen Abstand zur Elektrodenhalterung **1.** Der Spaltabstand muss mindestens so groß bemessen sein, dass bei der max. anliegenden Spannung kein Überschlag von Schutzring zur Elektrodenhalterung auftritt. Bevorzugt ist der Spaltabstand größer als 5 mm.

Da der Schutzring **4** keinen Kontakt zur spannungsführenden Elektrodenhalterung **1** hat und auch nicht zur Abdeckscheibe **5,** können beide Teile entweder aus einem elektrisch leitfähigen Material oder aus einem elektrisch nicht leitfähigem Material bestehen.

Für die spezifische Wärmeleitfähigkeit der Materialien beider Körper gilt ebenfalls keine Einschränkung. Das Aufwachsen einer dünnen Silicierungsschicht ist erlaubt.

Geeignete Materialien sind deshalb: Quarz, bevorzugt transluzentes Quarz, Grafit, bevorzugt Reinstgraphit, SiC, Graphit mit Silicium oder SiC Beschichtung, Si₃N₄, AlN, Al₂O₃, andere beständige Keramikwerkstoffe, beständige Metalle wie z.B. Ag oder Au.

Der radial umlaufende Schutzring **4** schirmt den Dichtkörper **2** vor heißer Gasströmung ab. Die Abdeckscheibe **5** auf der Elektrodenhalterung **1** verhindert, dass auf direktem Weg ein Siliciumsplitter an die Elektrodenhalterung **1** fällt und einen Erdschluss verursacht. Durch den radial umlaufenden Spalt wird ein elektrischer Kontakt zwischen dem Schutzring **4** und der Abdeckscheibe 5 ausgeschlossen.

Die Abdeckscheibe **5** kann aus einem elektrisch leitfähigen Material oder aus einem elektrisch nicht leitfähigen Material bestehen. Geeignete Materialien sind deshalb zum Beispiel: Quarz, bevorzugt transluzentes Quarz, Grafit, bevorzugt Reinstgraphit, SiC, Graphit mit Silicium oder SiC Beschichtung, Si₃N₄, AlN, Al₂O₃, andere beständige Keramikwerkstoffe, beständige Metalle wie z.B. Ag oder Au.

Eine eventuelle Silicierung (Aufwachsen einer dünnen Siliciumschicht während des Abscheideprozesses) hat keinen negativen Einfluss. Da keine Einschränkungen durch elektrische und thermische Leitfähigkeit gegeben sind, können kostengünstige Werkstoffe (z.B.: Graphit, Metalle) bevorzugt eingesetzt werden. Einziges Kriterium ist chemische und thermische Beständigkeit.

Weiterhin ist durch den Ringspalt ein guter Gasaustausch bei Spülprozessen möglich. Die Schutzkörper haben keinen Kontakt zum Dichtkörper, so dass sie die Wärme nicht durch Leitung übertragen können.

### Zweite bevorzugte Ausführungsform

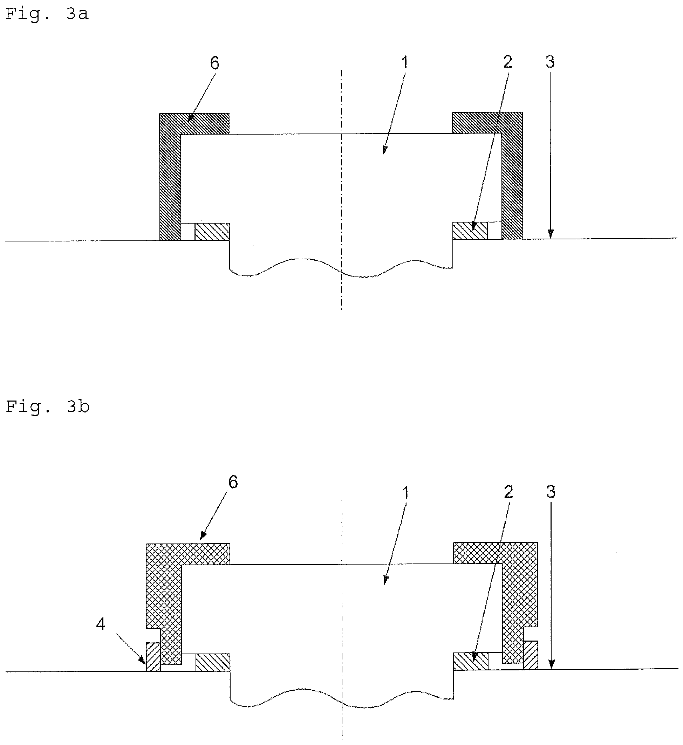

**Fig. 3a** zeigt eine zweite bevorzugte Ausführungsform.

Hier ist mindestens eine Abdeckung **6,** welche die Elektrodenhalterung **1** und die Bodenplatte **3** berührt, vorgesehen.

Die Abdeckung **6** umgibt den Dichtkörper **2** radial umlaufend.

Die Abdeckung **6** muss aus einem elektrisch isolierenden und sehr gut wärmeleitenden Material gefertigt werden. Somit ist keine Silicierung der Abdeckung **6** möglich.

Hierfür bietet sich Siliciumnitrid und Aluminiumnitrid oder weitere Keramikwerkstoffe mit hoher Wärmeleitfähigkeit bei Raumtemperatur von größer 10 W/mK, bevorzugt von größer als 50 W/mK bei Raumtemperatur, besonders bevorzugt von größer als 150 W/mK bei Raumtemperatur; und einem spezifischen elektrischem Widerstand bei Raumtemperatur von größer 10⁹ Ωcm, bevorzugt von größer als 10¹¹ Ωcm bei Raumtemperatur an.

Zur Erhöhung der Wärmeableitung der Abdeckung **6** kann die Abdeckung **6** bevorzugt fest mit der gekühlten Elektrodenhalterung **1** verbunden sein, z.B. durch ein Schraubgewinde (in der Abbildung nicht dargestellt) am Umfang der Elektrodenhalterung **1.**

Die radial umlaufende Abdeckung **6** aus einem elektrischen Isolator mit den beschriebenen Eigenschaften vereint die Funktion des Splitterschutzes und des thermischen Schutzes des Dichtkörpers **2.**

Die Abdeckung **6** muss die gekühlte Bodenplatte **3** und die gekühlte Elektrodenhalterung **1** berühren.

Durch die hohe Wärmeleitfähigkeit ist die Oberflächentemperatur der Abdeckung **6** durch Ableitung der Wärme zur gekühlten Elektrodenhalterung **1** und zur gekühlten Bodenplatte **3** so niedrig, das keine elektrisch leitfähige Siliciumschicht aufwachsen kann.

Durch den hohen spezifischen elektrischen Widerstand treten keine Erdschlüsse über der Abdeckung **6** auf.

Durch die vollständige Kapselung können herabfallende Siliciumsplitter keine Erdschlüsse auslösen, da kein Kontakt mit Elektrodenhalterung **1** und Bodenplatte **3** möglich ist.

Die Abdeckung **6** schirmt den Dichtkörper **2** weiterhin vor heißer Gasströmung ab.

Die Abdeckung **6** hat keinen Kontakt zum Dichtkörper **2,** so dass die Wärme nicht durch Leitung übertragen werden kann.

Für diese Variante sind Materialeigenschaften wie hohe spezifische Wärmeleitfähigkeit von größer als 10 W/mK, bevorzugt von größer als 50 W/mK, besonders bevorzugt von größer als 150 W/mK, hoher spezifischer elektrischer Widerstand (Isolator) von größer als 10⁹ Ωcm, sowie chemische und thermische Beständigkeit und hohe Reinheit notwendig. Geeignete Materialien sind: Si₃N₄ (Siliciumnitrid), AlN (Aluminiumnitrid) oder andere Keramikwerkstoffe, die die genannten Kriterien erfüllen.

**Fig. 3b** zeigt eine Modifikation der in **Fig. 3a** dargestellten Ausführungsform.

Eine bevorzugte Weiterentwicklung besteht in einer Kombination der Abdeckung **6** mit einem Schutzring **4.**

Die Abdeckung **6** ist in ihrer seitlichen Flanke mit der Elektrodenhalterung **1** vertikal zur Bodenplatte **3** bewegbar.

Die Kombination besteht aus einem unteren Schutzring **4,** der auf der Bodenplatte aufliegt, und der Abdeckung **6,** der auf der Elektrodenhalterung aufliegt und mit ihr bevorzugt fest verbunden ist z.B. in Form einer Schraubverbindung.

Dadurch wird gewährleistet, dass die Abdeckung 6 Fertigungstoleranzen von Elektrodenhalterung **1** und Setzverhalten des Dichtkörpers **2** ausgleichen kann.

Abdeckung **6** und Schutzring **4** sind so bemessen, dass Schutzring **4** und Abdeckung **6** in einander greifen und eine ständige Überlappung gewährleisten. Dadurch ist auch bei Fertigungstoleranzen der Elektrodenhalterung **1** sowie beim Setzen der Dichtkörper **2** immer sicher gestellt, dass die Abdeckung **6** auf der Elektrodenhalterung **1** aufliegt und an der seitlichen Flanke der Abdeckung **6** immer eine Überlappung mit dem Schutzring **4** besteht.

Eine Überlappung der seitlichen Flanke der Abdeckung **6** mit dem Schutzring **4** gewährleistet eine vollkommene Abschottung der Elektrodenhalterung **1** im Bereich des Dichtkörpers **2** vom Reaktorraum.

Zur besseren Durchlüftung des eingeschlossenen Raumes um die Elektrodenhalterung **1** während Spülschritten zur Inertisierung des Abscheidereaktors kann die Abdeckung **6** und / oder der Schutzring **4** an dem Umfang und / oder an der Oberseite kleine Bohrungen (nicht in der Abbildung dargestellt) enthalten.

Für diese Variante sind Materialeigenschaften von Abdeckung **6** und Schutzring **4** wie hohe spezifische Wärmeleitfähigkeit von größer als 10 W/mK bei Raumtemperatur, bevorzugt von größer als 50 W/mK bei Raumtemperatur, besonders bevorzugt von größer als 150 W/mK bei Raumtemperatur, hoher spezifischer elektrischer Widerstand (Isolator) bei Raumtemperatur von größer als 10⁹ Ωcm, bevorzugt von größer als 10¹¹ Ωcm bei Raumtemperatur, sowie chemische und thermische Beständigkeit und hohe Reinheit notwendig. Geeignete Materialien sind: Si₃N₄ (Siliciumnitrid), AlN (Aluminiumnitrid) oder andere Keramikwerkstoffe, die die genannten Kriterien erfüllen.

### Dritte bevorzugte Ausführungsform

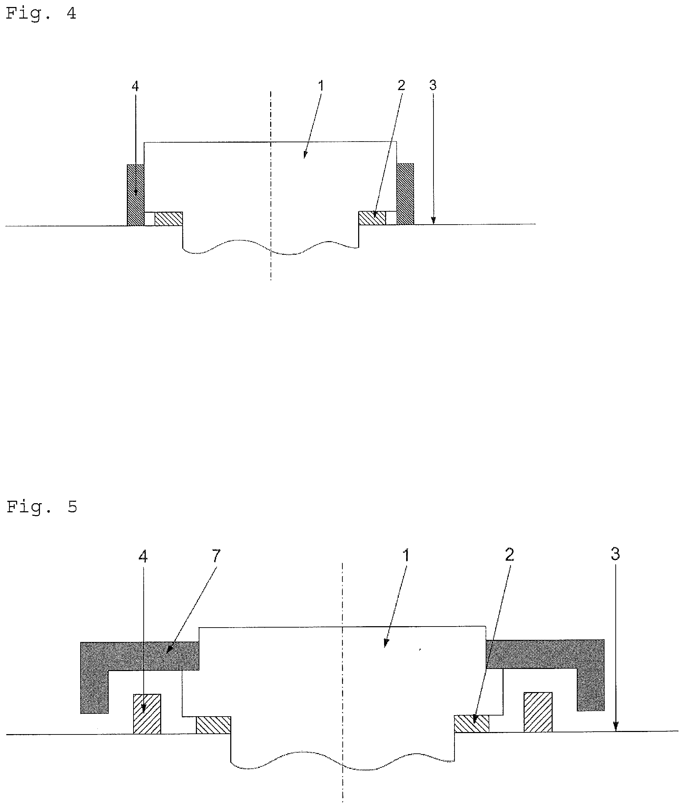

**Fig. 4** zeigt die dritte bevorzugte Ausführungsform.

Diese Ausführungsform sieht einen Schutzring **4** aus einem elektrisch nicht leitenden Werkstoff dar.

Die Schutzring **4** muss aus einem elektrisch isolierenden und sehr gut wärmeleitenden Material gefertigt werden. Hierfür bieten sich Siliciumnitrid und Aluminiumnitrid oder weitere Keramikwerkstoffe mit hoher Wärmeleitfähigkeit (bei Raumtemperatur) größer 10 W/mK, bevorzugt von größer als 50 W/mK, besonders bevorzugt von größer als 150 W/mK; und einem spezifischen elektrischem Widerstand (bei Raumtemperatur) von größer als 10⁹ Ωcm, bevorzugt größer als 10¹¹ Ωcm an.

Der Schutzring **4** umgibt den Dichtkörper **2** und die Elektrodenhalterung **1** radial umlaufend und stellt einen Kontakt zwischen gekühlter Elektrodenhalterung **1** und gekühlter Bodenplatte **3** zwecks Wärmeableitung her.

Der Schutzring **4** kann sowohl aus einem Stück bestehen oder aus beliebig vielen Teilstücken zu einem Ring zusammengesetzt sein.

Im Falle eines einteiligen Schutzrings **4** kann der Schutzring **4** lösbar fest verbunden mit der Elektrodenhalterung **1** sein, z.B. durch eine Schraubverbindung (in der Abbildung nicht dargestellt).

Dadurch wird der Wärmeübergang vom Schutzring **4** zur gekühlten Elektrodenhalterung **1** erhöht, was zu niedrigeren Oberflächentemperaturen am Schutzring **4** führt. Dies hat Vorteile bezüglich höherer Standzeit (geringere thermische und chemische Korrosion) und geringerer Oberflächentemperatur des Schutzrings **4.**

Um den Schutzring **4** kann ein äußerer Schutzring (nicht dargestellt) aus Quarz, Keramik, oder einem beständigen Metall (z.B.: Silber, Edelstahl, Gold) beabstandet angeordnet sein. Der optionale Schutzring schirmt den inneren Schutzring **4** zusätzlich von Wärmestrahlung der Siliciumstäbe und heißer Gasströmung ab. Dadurch wird der innere Schutzring **4** weniger thermisch belastet.

Der radial umlaufende Schutzring **4** aus einem elektrischen Isolator mit den beschriebenen Eigenschaften vereint die Funktion des Splitterschutzes und des thermischen Schutzes des Dichtkörpers **2.**

Der Schutzring **4** muss die gekühlte Bodenplatte **3** und die gekühlte Elektrodenhalterung **1** berühren.

Durch die hohe Wärmeleitfähigkeit ist die Oberflächentemperatur des Schutzrings **4** durch Ableitung der Wärme zur gekühlten Elektrodenhalterung **1** und zur gekühlten Bodenplatte **3** so niedrig, das keine elektrisch leitfähige Siliciumschicht aufwachsen kann.

Durch den hohen spezifischen elektrischen Widerstand treten keine Erdschlüsse über dem Schutzring **4** auf.

Durch die vollständige Kapselung können herabfallende Siliciumsplitter keine Erdschlüsse auslösen, da kein Kontakt der Splitter mit Elektrodenhalterung **1** und Bodenplatte **3** möglich ist.

Der Schutzring **4** schirmt den Dichtkörper **2** weiterhin vor heißer Gasströmung ab.

Der Schutzring **4** hat keinen Kontakt zum Dichtkörper **2,** so dass die Wärme nicht durch Leitung übertragen werden kann.

Durch den optionalen äußeren Schutzring wird der Effekt der thermischen Abschirmung nochmals verstärkt.

### Vierte bevorzugte Ausführungsform

**Fig. 5** zeigt die vierte bevorzugte Ausführungsform.

Diese Ausführungsform sieht mindestens einen Schutzring **4** auf der Bodenplatte **3** in Kombination mit einer Abdeckkappe **7** auf der Elektrodenhalterung **1** vor.

Der Schutzring **4** umgibt den Dichtkörper **2** radial umlaufend.

Abdeckkappe **7** und Schutzring **4** sind so überlappend, dass kein Kontakt zwischen Abdeckkappe **7** und Schutzring **4** besteht.

Weiterhin überlappen sich Abdeckkappe **7** und Schutzring **4** in vertikaler Richtung so, dass kein geradliniger Durchgang zum Dichtkörper **2** möglich ist.

Dadurch können keine Siliciumsplitter zum Dichtkörper **2** gelangen.

Da der Schutzring **4** keinen Kontakt zur spannungsführenden Elektrodenhalterung **1** hat und auch nicht zur Abdeckkappe **7,** können beide Teile entweder aus einem elektrisch leitfähigem Material oder aus einem elektrisch nicht leitfähigem Material bestehen.

Für die spezifische Wärmeleitfähigkeit der Materialien beider Körper gilt ebenfalls keine Einschränkung. Das Aufwachsen einer dünnen Silicierungsschicht ist erlaubt.

Geeignete Materialien sind deshalb: Quarz, bevorzugt transluzentes Quarz, Grafit, bevorzugt Reinstgraphit, SiC, Graphit mit Silicium oder SiC Beschichtung, Si₃N₄, AlN, Al₂O₃, andere beständige Keramikwerkstoffe, beständige Metalle wie z.B. Ag oder Au.

Zur besseren Wärmeabfuhr von Abdeckkappe **7** zur gekühlten Elektrodenhalterung **1** kann die Abdeckkappe **7** fest mit der Elektrodenhalterung **1** verbunden sein, z.B. mit einer Schraubverbindung.

Der radial umlaufende Schutzring **4** schirmt den Dichtkörper **2** vor heißer Gasströmung ab.

Die Abdeckkappe **7** auf der Elektrodenhalterung **1** mit in Richtung Bodenplatte **3** heruntergezogenem Rand verhindert, dass auf direktem oder indirektem Weg durch die vertikale Überlappung von Abdeckkappe **7** und Schutzring **4** ein Siliciumsplitter an die Elektrodenhalterung **1** und den Dichtkörper **2** fällt und somit einen Erdschluss verursacht.

Durch die vertikale Überlappung der Abdeckkappe **7** und des Schutzrings **4** und ausreichend großem Abstand von 3 - 40 mm, bevorzugt 5 - 10 mm, zwischen Abdeckkappe **7** und Schutzring **4** kann ein elektrischer Kontakt der silicierten Teile ausgeschlossen werden.

Der Abstand von Abdeckkappe **7** und Bodenplatte **3** muss mindestens so groß bemessen sein, dass bei der max. anliegenden Spannung kein Überschlag von Abdeckkappe zur Bodenplatte auftritt. Bevorzugt ist der Spaltabstand größer als 5 mm.

Weiterhin ist durch die vertikale Überlappung ein guter Gasaustausch innerhalb der Abdeckkappe **7** im Bereich der Elektrodenhalterung **1** bei Spülprozessen möglich.

Abdeckkappe **7** und Schutzring **4** haben keinen Kontakt zum Dichtkörper **2,** sodass sie die Wärme nicht durch Leitung übertragen können.

### Fünfte bevorzugte Ausführungsform

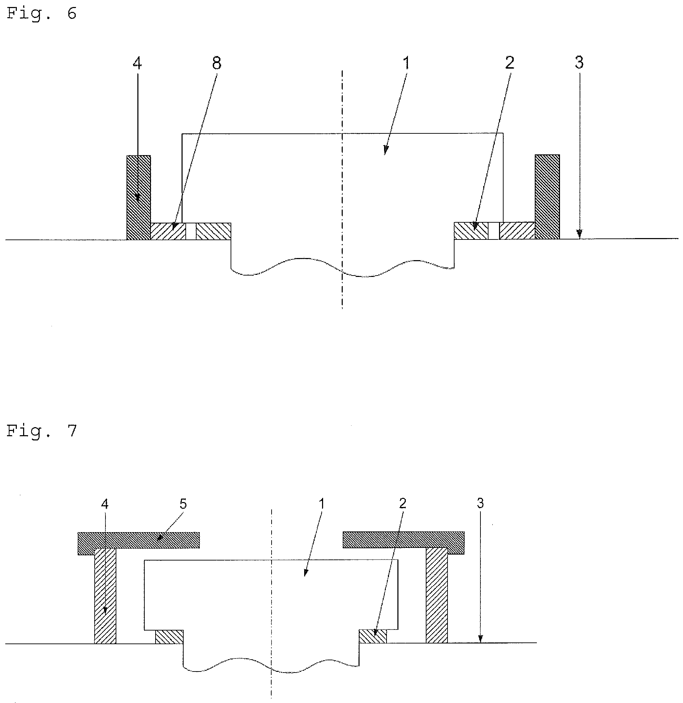

**Fig. 6** zeigt eine fünfte bevorzugte Ausführungsform.
Diese Ausführungsform sieht mindestens einen Schutzring **4** auf der Bodenplatte **3** in Kombination mit Ringsegmenten **8,** die zwischen Elektrodenhalterung **1** und Bodenplatte **3** geschoben werden und die Bodenplatte **3** mindestens zwischen Elektrodenhalterung und Schutzring **4** bedecken.

Die Ringsegmente **8** lassen sich zu einem vollständigen Ring zusammensetzen.

Die Ringsegmente **8** werden zwischen Elektrodenhalterung 1 und Bodenplatte **3** zum Dichtkörper **2** hin eingeschoben, wobei die Ringsegmente **8** so bemessen sind, dass nach dem Einschieben zwischen Elektrodenhalterung **1** und Bodenplatte **3** ein Abstand vom Ringsegment **8** zum Dichtkörper **2** von 0 - 20 mm, bevorzugt 2 - 5 mm besteht.

Anstelle von Ringsegmenten **8** kann auch ein kompletter Ring, der bei der Montage der Elektrodenhalterung **1** in die Bodenplatte **3** zwischen Bodenplatte **3** und Elektrodenhalterung **1** eingebaut wird, verwendet werden.

Der Schutzring **4** und die Ringsegmente **8** sind aus einem elektrisch isolierenden Material mit einem spezifischen elektrischen Widerstand von größer als 10⁹ Ωcm bei Raumtemperatur, bevorzugt von größer als 10¹¹ Ωcm bei Raumtemperatur und einer spezifischen Wärmeleitfähigkeit von größer als 1 W/mK bei Raumtemperatur, bevorzugt von größer als 20 W/mK bei Raumtemperatur, besonders bevorzugt von größer als 150 W/mK bei Raumtemperatur. Geeignete Materialien sind z.B. Quarz, bevorzugt transluzentes Quarz, Si₃N₄, AlN, Al₂O₃, oder andere entsprechende Keramikwerkstoffe.

Aufgrund der bevorzugten geringen Dicke der Ringsegmente **8** zwischen 3 und 20 mm, besonders bevorzugt 3 - 10 mm, ganz besonders bevorzugt 3 - 7 mm, der hohen spezifischen Wärmeleitfähigkeit und der großen Auflagefläche zur gekühlten Bodenplatte **3,** kann die von den Ringsegmenten **8** aufgenommene Strahlungswärme von den Stabfüßen gut über die gekühlte Bodenplatte **3** abgeführt werden.

Die Oberflächentemperatur der Ringsegmente **8** ist deshalb so niedrig, dass unter Abscheidebedingungen keine Silicierung an ihrer Oberfläche möglich ist. Somit ist auch keine elektrische Leitfähigkeit gegeben.

Der Schutzring **4** hat vorzugsweise einen Abstand von 5 - 50 mm, besonders bevorzugt 5 - 20 mm, ganz besonders bevorzugt 5 - 10 mm zur Elektrodenhalterung **1.** Daher genügt es, wenn die Schutzringe **4** im Bereich zwischen 0 und 5 mm zur Bodenplatte **3** hin frei bleiben von Silicierung.
Dies ist aufgrund der guten Wärmeabfuhr zur Bodenplatte **3** mit der angegebenen spezifischen Wärmleitfähigkeit des Schutzringes **4** gegeben.

Durch die Abdeckung der Bodenplatte **3** stellt diese Kombination einen wirksamen Splitterschutz dar, da durch die Ringsegmente **8** kein elektrischer Kontakt eines Siliciumsplitters mit der Elektrodenhalterung **1** und der Bodenplatte **3** möglich ist. Gleichzeitig wird der Dichtkörper **2** in Verbindung mit den Ringsegmenten **8** und dem Schutzring **4** besser vor heißem Reaktorgas geschützt.

Die Ringsegmente **8** decken die Bodenplatte zwischen Schutzring **4** und Elektrodenhalterung **1** vollständig ab. Durch die notwendige hohe spezifische Wärmeleitfähigkeit der Ringsegmente **8** und des Schutzrings **4** von größer als 1 W/mK bei Raumtemperatur, bevorzugt von größer als 20 W/mK bei Raumtemperatur, besonders bevorzugt von größer als 150 W/mK bei Raumtemperatur und des hohen spezifischen elektrischen Widerstands (Isolator) von größer als 10⁹ Ωcm bei Raumtemperatur, bevorzugt von größer als 10¹¹ Ωcm bei Raumtemperatur, wird die Bodenplatte **3** vollständig elektrisch gegenüber der Elektrodenhalterung **1** abgeschirmt. Dies stellt einen wirksamen Splitterschutz dar.

Gegenüber dem Stand der Technik bewirken die Ringsegmente **8** einen zusätzlichen thermischen Schutz des Dichtkörpers **2** und einen zusätzlichen Schutz gegenüber Erdschlüssen zwischen Elektrodenhalterung **1** und Schutzring **4,** hervorgerufen durch Siliciumsplitter.

Weiterhin wird durch die hohe Wärmeleitfähigkeit des Schutzrings **4** und der Ringsegmente **8** aufgenommene Wärme (Reaktionsgas und Strahlung) an die gekühlte Bodenplatte **3** abgegeben, sodass die Oberflächentemperatur von Schutzring **4** und Ringsegmenten **8** nicht so heiß wird, dass die Ringsegmente **8** silicieren könnten, beziehungsweise die Schutzring **4** und Ringsegmente **8** im Bereich zur Bodenplatte **3** hin silicieren könnten.

Ein weiterer Vorteil ist, dass durch die niedrige Oberflächentemperatur von Schutzring **4** und Ringsegmenten **8** der Dichtkörper **2** weniger stark durch Strahlung thermisch beansprucht wird.

Zusätzlich ist der Dichtkörper **2** vom heißen Reaktionsgas vollständig abgeschirmt. Die Ringsegmente **8** sind so dimensioniert, dass sie keinen Kontakt zum Dichtkörper **2** haben, so dass Wärme nicht durch Leitung an den Dichtkörper **2** übertragen werden kann.

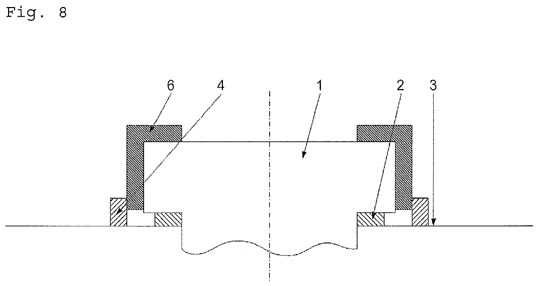

**Fig. 7** und **Fig. 8** zeigen weitere mögliche Ausführungen.

**Fig. 7** zeigt einen Schutzring **4** mit aufliegender Scheibe **5.** Bei dieser Ausführung können Schutzring **4** und Scheibe **5** aus einem elektrisch leitenden oder einem elektrisch nichtleitenden Material mit beliebiger spez. Wärmeleitfähigkeit sein. Zwischen Scheibe **5** und Elektrodenhalterung **1** muss ein Abstand von mindestens **5** mm sein sowie zwischen Schutzring **4** und Elektrodenhalterung **1** muss ebenfalls ein Abstand von mindestens 5 mm sein.

**Fig. 8** zeigt eine Ausführung mit vertikal verschiebbaren Schutzkörpern. Es sind eine umlaufende Abdeckung **6** aus einem elektrischen Nichtleiter und ein umlaufender Schutzring **4** aus einem elektrischen Nichtleiter vorgesehen.

### Beispiele und Vergleichsbeispiele

In einem Siemens-Abscheidereaktor wurden polykristalline Siliciumstäbe mit einem Durchmesser zwischen 160 und 230 mm abgeschieden. Dabei wurden mehrere Ausführungen an Schutzkörpern getestet. Die Parameter des Abscheideprozesses waren bei allen Versuchen jeweils gleich. Die Versuche unterschieden sich nur in der Ausführung der Schutzkörper. Die Abscheidetemperatur lag im Chargenverlauf zwischen 1000°C und 1100°C. Während des Abscheideprozesses wurde ein Feed bestehend aus einer oder mehreren chlorhaltigen Silanverbindungen der Formel SiHₙCl₄₋ₙ (mit n = 0 bis 4) und Wasserstoff als Trägergas zugegeben.

### Vergleichsbeispiel

CVD-Reaktor mit einfachem Schutzkörper für Dichtkörper, wie in **Fig. 1** dargestellt.

Bei dieser Ausführung nach dem Stand der Technik wird nur ein einfacher Ring aus transluzentem Quarz zum Schutz des Dichtkörpers mit einem Abstand von 10 mm um die Elektrodenhalterung gestellt. Von 100 Chargen sind 20 Chargen während der Abscheidung durch Erdschluss ausgefallen. Ausfallursache waren Si-Splitter, die aufgrund von thermischen Verspannungen wegen des hohen Feeddurchsatzes von den Siliciumstäben abplatzten. Diese fielen zwischen Elektrodenhalterung und Quarzring und stellten dort eine elektrisch leitende Verbindung zwischen Elektrodenhalterung und Bodenplatte her. Wegen der hohen thermischen Belastung des Dichtkörpers aufgrund unzureichender Schutzwirkung des Quarzrings war die Standzeit des Dichtkörpers auf 2 Monate begrenzt. Aufgrund der thermischen Belastung durch das heiße Reaktionsgas war sowohl die Abdichtung der Bodenplatte als auch die elektrische Isolation durch thermisches Cracken und setzen des Dichtkörpers nicht mehr gegeben. Nach dieser Zeit war deshalb ein aufwendiger Tausch aller Dichtkörper notwendig. Chargenausfall und Reparaturarbeiten hatten einen erheblichen Kapazitätsverlust zur Folge.

### Beispiel 1 (gemäß der ersten bevorzugten Ausführungsform)

Auf die Elektrodenhalterung wird eine Abdeckscheibe aus Reinstgraphit gelegt. Zum Schutz des Dichtkörpers wird ein Ring aus transluzentem Quarz mit einem Abstand von 10 mm um die Elektrodenhalterung gestellt. Die Abdeckscheibe ist so dimensioniert, dass sie die Elektrodenhalterung und mindestens den Bereich der Bodenplatte mit dem Quarzring von oben abschirmt. Aufgrund der hohen Gasraumtemperatur siliciert der Quarzring und die Abdeckscheibe während der Abscheidung mit einer dünnen Siliciumschicht. Zwischen Abdeckplatte und Quarzring ist ein umlaufender Spalt so dimensioniert, dass zwischen Quarzring und Abdeckscheibe bei der anliegenden Spannung kein elektrischer Überschlag von Abdeckscheiben zum Quarzring auftreten kann.
Von 100 Chargen sind 5 Chargen durch Erdschluss ausgefallen. Einzelne Siliciumsplitter gelangten durch den umlaufenden Spalt zur Elektrodenhalterung und führten zum Erdschluss zwischen Elektrodenhalterung und Bodenplatte.
Aufgrund der zusätzlichen Abschirmung der Abdeckscheiben verlängerte sich die Standzeit des Dichtkörpers auf 4 Monate.

### Beispiel 2 (gemäß der zweiten bevorzugten Ausführungsform)

Elektrodenhalterung und Dichtkörper werden durch Auflegen einer Kappe aus Aluminiumnitrid geschützt. Bei dieser Ausführungsform hat die Kappe sowohl oberhalb als auch am zylindrischen Teil der Elektrodenhalterung Kontakt mit der Elektrodenhalterung und reicht bis auf die Bodenplatte. Aufgrund der hohen spezifischen Wärmeleitfähigkeit von 180 W/mK (bei Raumtemperatur), sowie der Abführung der aufgenommenen Wärme durch Reaktionsgas und Wärmeleitung über die gekühlten Kontaktflächen ist die Oberflächentemperatur so niedrig, dass keine Silicierung der Kappenoberfläche auftritt. Weiterhin ist der Kappenwerkstoff elektrisch isolierend. Durch die vollständige Kapselung des Dichtkörpers kann kein Erdschluss, verursacht durch Siliciumsplitter auftreten. Entsprechend war die Erdschlussquote von 100 Chargen 0%. Die Standzeit des Dichtkörpers erhöhte sich aufgrund der niedrigeren Kappentemperatur auf 9 Monate.

### Beispiel 3 (gemäß der dritten bevorzugten Ausführungsform)

Elektrodenhalterung und Dichtkörper werden durch Anlegen eines Schutzrings aus Aluminiumnitrid geschützt. Der Schutzring hat Kontakt zur gekühlten Elektrodenhalterung und zur gekühlten Bodenplatte. Aufgrund der hohen spezifischen Wärmeleitfähigkeit von 180 W/mK bei Raumtemperatur, sowie der Abführung der aufgenommenen Wärme durch Reaktionsgas und Wärmeableitung über die gekühlten Kontaktflächen ist die Oberflächentemperatur so niedrig, dass keine Silicierung der Ringoberfläche auftritt. Weiterhin ist der Ringwerkstoff elektrisch isolierend. Durch die vollständige Kapselung des Dichtkörpers kann kein Erdschluss, verursacht durch Siliciumsplitter auftreten. Entsprechend war die Erdschlussquote von 100 Chargen 0%. Die Standzeit des Dichtkörpers erhöhte sich aufgrund der niedrigeren Ringtemperatur auf 9 Monate.

### Beispiel 4 (gemäß der vierten bevorzugten Ausführungsform)

Elektrodenhalterung und Dichtkörper werden durch die Kombination von Schutzring und Abdeckkappe geschützt. Der Schutzring bestand aus transluzentem Quarz und die Abdeckkappe aus Reinstgraphit. Die Schutzkörper wurden so angeordnet, dass kein elektrischer Kontakt zwischen beiden möglich war. Es bestand eine vertikale Überlappung von Kappenrand und Schutzring, sodass keine Siliciumsplitter zum Dichtkörper gelangen konnten. Entsprechend war die Erdschlussquote 0%. Durch die vertikale Überlappung von Kappenrand und Schutzring, wurde der Dichtkörper besonders gut thermisch geschützt. Die Standzeit des Dichtkörpers erhöhte sich auf 7 Monate.

### Beispiel 5 (gemäß der fünften bevorzugten Ausführungsform)

Elektrodenhalterung und Dichtkörper werden durch Kombination von Ringsegmenten und Schutzring geschützt. Ringsegmente und Schutzring waren aus Aluminiumnitridring mit einer spezifischen Wärmeleitfähigkeit von 180 W/mK bei RT gefertigt. Durch den Kontakt mit der gekühlten Bodenplatte konnte die aufgenommen Wärme gut abgeführt werden. Weiterhin ist der Schutzkörperwerkstoff elektrisch isolierend. Durch die vollständige Kapselung des Dichtkörpers kann kein Erdschluss, verursacht durch Siliciumsplitter auftreten. Entsprechend war die Erdschlussquote 0%. Die Standzeit des Dichtkörpers erhöhte sich aufgrund der niedrigeren Ringsegmenttemperatur auf 9 Monate.

## Patentansprüche

1. Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist,
und wobei ein radial die Elektrodenhalterung (1) und den Dichtkörper (2) umlaufender Schutzring (4), der die Bodenplatte berührt,
und eine Abdeckkappe (7), die auf der Elektrodenhalterung (1) aufliegt, jedoch nicht die Bodenplatte (3) berührt, wobei die Abdeckkappe (7) über dem Schutzring (4) angeordnet ist, diesen jedoch nicht berührt, vorgesehen sind.

2. Vorrichtung nach Anspruch 1, wobei die Abdeckkappe (7) einen in Richtung Bodenplatte (3) heruntergezogenen Rand umfasst, so dass Abdeckkappe (7) und Schutzring (4) in vertikaler Richtung überlappen.

3. Vorrichtung nach Anspruch 1 oder nach Anspruch 2, wobei ein Abstand zwischen Abdeckkappe (7) und Schutzring (4) von 3 bis 40 mm beträgt.

4. Vorrichtung nach einem der Ansprüche 1 bis 3, wobei ein Abstand zwischen Abdeckkappe (7) und Bodenplatte (3) mehr als 5 mm beträgt.

5. Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist,
und wobei ein radial die Elektrodenhalterung (1) und den Dichtkörper (2) umlaufender Schutzring (4), der die Bodenplatte berührt,
und eine Abdeckung (6), die die Elektrodenhalterung (1) seitlich und von oben berührt, wobei kein Kontakt zwischen Abdeckung (6) und Bodenplatte (3) besteht, wobei der Schutzring (4) gegen die Abdeckung (6) seitliche versetzt ist, wobei der Schutzring (4) eine seitliche Lücke zwischen Abdeckung (6) und Bodenplatte (3) schließt, vorgesehen sind.

6. Vorrichtung nach Anspruch 5, wobei Abdeckung (6) in vertikaler Richtung beweglich ist und Schutzring (4) und Abdeckung (6) aus einem elektrischen isolierenden Material mit einem spezifischen elektrischen Widerstand von größer als 10⁹ Ωcm bei Raumtemperatur bestehen.

7. Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist,
und wobei ein radial die Elektrodenhalterung (1) und den Dichtkörper (2) umlaufender Schutzring (4), der die Bodenplatte berührt,
und eine radial die Elektrodenhalterung (1) und den Dichtkörper (2) umlaufende Abdeckung (6), die die Elektrodenhalterung (1) und die Bodenplatte (3) berührt, vorgesehen ist, wobei die Abdeckung (6) die Elektrodenhalterung sowohl seitlich als auch von oben berührt und die Abdeckung (6) aus einem elektrischen isolierenden Material mit einem spezifischen elektrischen Widerstand von größer als 10⁹ Ωcm bei Raumtemperatur besteht, das zugleich eine Wärmeleitfähigkeit von größer als 10 W/mK bei Raumtemperatur aufweist.

8. Vorrichtung zum Schutz einer Elektrodendichtung in einem Reaktor zur Abscheidung von polykristallinem Silicium, wobei in einem Zwischenraum zwischen Elektrodenhalterung (1) der Elektrode und Bodenplatte (3) des Reaktors ein Dichtkörper (2) angeordnet ist,
und wobei ein radial die Elektrodenhalterung (1) und den Dichtkörper (2) umlaufender Schutzring (4), der die Bodenplatte berührt, und den Schutzring (4) und die Elektrodenhalterung (1) radial umlaufende Ringsegmente (8) vorgesehen sind, wobei der Schutzring (4) weiter von der Elektrodenhalterung (1) beabstandet ist als die Ringsegmente (8), und wobei sowohl Schutzring (4) als auch Ringsegmente (8) aus einem elektrischen isolierenden Material mit einem spezifischen elektrischen Widerstand von größer als 10⁹ Ωcm-bei Raumtemperatur bestehen, das zugleich eine spezifische Wärmeleitfähigkeit von größer als 1 W/mK bei Raumtemperatur aufweist.

9. Verfahren zur.Herstellung von polykristallinem Silicium, umfassend Einleiten eines Reaktionsgases enthaltend eine Silicium enthaltende Komponente und Wasserstoff in einen CVD Reaktor enthaltend wenigstens einen Filamentstab, der sich auf einer Vorrichtung gemäß einem der Ansprüche 1 bis 8 befindet, der mittels der Elektrode mit Strom versorgt und der damit durch direkten Stromdurchgang auf eine Temperatur aufgeheizt wird, bei der sich polykristallines Silicium am. Filamentstab abscheidet.

## Claims

1. Device for protecting an electrode seal in a reactor for the deposition of polycrystalline silicon, wherein a sealing body (2) is arranged in an intermediate space between an electrode holder (1) of the electrode and a base plate (3) of the reactor, and wherein a protective ring (4) which extends radially around the electrode holder (1) and the sealing body (2) and touches the base plate is provided,
and a cover cap (7) which bears on the electrode holder (1) but does not touch the base plate (3) is provided, wherein the cover cap (7) is arranged above the protective ring (4) but does not touch it.

2. Device according to Claim 1, wherein the cover cap (7) comprises an edge drawn down in the direction of the base plate (3) such that the cover cap (7) and the protective ring (4) overlap in the vertical direction.

3. Device according to Claim 1 or according to Claim 2, wherein a distance between the cover cap (7) and the protective ring (4) is from 3 to 40 mm.

4. Device according to one of Claims 1 to 3, wherein a distance between the cover cap (7) and the base plate (3) is more than 5 mm.

5. Device for protecting an electrode seal in a reactor for the deposition of polycrystalline silicon, wherein a sealing body (2) is arranged in an intermediate space between an electrode holder (1) of the electrode and a base plate (3) of the reactor, and wherein a protective ring (4) which extends radially around the electrode holder (1) and the sealing body (2) and touches the base plate is provided,
and a cover (6) which touches the electrode holder (1) laterally and from above is provided, wherein there is no contact between the cover (6) and the base plate (3), wherein the protective ring (4) is laterally offset relative to the cover (6), wherein the protective ring (4) closes a lateral gap between the cover (6) and the base plate (3).

6. Device according to Claim 5, wherein the cover (6) is mobile in the vertical direction and the protective ring (4) and the cover (6) consist of an electrically insulating material having an electrical resistivity of more than 10⁹ Ωcm at room temperature.

7. Device for protecting an electrode seal in a reactor for the deposition of polycrystalline silicon, wherein a sealing body (2) is arranged in an intermediate space between an electrode holder (1) of the electrode and a base plate (3) of the reactor, and wherein a protective ring (4) which extends radially around the electrode holder (1) and the sealing body (2) and touches the base plate is provided,
and a cover (6) which extends radially around the electrode holder (1) and the sealing body (2) and touches the electrode holder (1) and the base plate (3) is provided, wherein the cover (6) touches the electrode holder both laterally and from above, and the cover (6) consists of an electrically insulating material having an electrical resistivity at room temperature of more than 10⁹ Ωcm, which also has a thermal conductivity at room temperature of more than 10 W/mK.

8. Device for protecting an electrode seal in a reactor for the deposition of polycrystalline silicon, wherein a sealing body (2) is arranged in an intermediate space between an electrode holder (1) of the electrode and a base plate (3) of the reactor, and wherein a protective ring (4) which extends radially around the electrode holder (1) and the sealing body (2) and touches the base plate, and ring segments (8) extending radially around the protective ring (4) and the electrode holder (1), are provided, wherein the protective ring (4) is separated further from the electrode holder (1) than the ring segments (8), and wherein both the protective ring (4) and the ring segments (8) consist of an electrically insulating material having an electrical resistivity at room temperature of more than 10⁹ Ωcm, which also has a thermal conductivity at room temperature of more than 1 W/mK.

9. Method for producing polycrystalline silicon, comprising introduction of a reaction gas containing a silicon-containing component and hydrogen into a CVD reactor containing at least one filament rod, which is located on a device according to one of Claims 1 to 8 and is supplied with current by means of the electrode, and which is thereby heated by direct current flow to a temperature at which polycrystalline silicon is deposited on the filament rod.

## Revendications

1. Dispositif servant à protéger un joint d'étanchéité pour électrode dans un réacteur servant à déposer du silicium polycristallin, dans lequel un corps d'étanchéité (2) est agencé dans un espace intermédiaire entre le porte-électrode (1) de l'électrode et la plaque de fond (3) du réacteur,
et dans lequel une bague de protection (4) entourant radialement le porte-électrode (1) et le corps d'étanchéité (2), qui est en contact avec la plaque de fond,
et un capuchon de recouvrement (7), qui est disposé sur le porte-électrode (1), mais qui n'est toutefois pas en contact avec la plaque de fond (3), le capuchon de recouvrement (7) étant agencé au-dessus de la bague de protection (4) mais n'étant toutefois pas en contact avec celle-ci, sont prévus.

2. Dispositif selon la revendication 1, dans lequel le capuchon de recouvrement (7) comprend un bord tiré vers le bas dans la direction de la plaque de fond (3), de sorte que le capuchon de recouvrement (7) et la bague de protection (4) se chevauchent dans la direction verticale.

3. Dispositif selon la revendication 1 ou la revendication 2, dans lequel un écart entre le capuchon de recouvrement (7) et la bague de protection (4) est de 3 à 40 mm.

4. Dispositif selon l'une quelconque des revendications 1 à 3, dans lequel un écart entre le capuchon de recouvrement (7) et la plaque de fond (3) est de plus de 5 mm.

5. Dispositif servant à protéger un joint d'étanchéité pour électrode dans un réacteur servant à déposer du silicium polycristallin, dans lequel un corps d'étanchéité (2) est agencé dans un espace intermédiaire entre le porte-électrode (1) de l'électrode et la plaque de fond (3) du réacteur,
et dans lequel une bague de protection (4) entourant radialement le porte-électrode (1) et le corps d'étanchéité (2), qui est en contact avec la plaque de fond,
et un recouvrement (6), qui est en contact avec le porte-électrode (1) latéralement et par le haut, aucun contact n'existant entre le recouvrement (6) et la plaque de fond (3), la bague de protection (4) étant décalée latéralement par rapport au recouvrement (6), la bague de protection (4) fermant un espace latéral entre le recouvrement (6) et la plaque de fond (3), sont prévus.

6. Dispositif selon la revendication 5, dans lequel le recouvrement (6) est mobile dans la direction verticale et la bague de protection (4) et le recouvrement (6) sont constitués par un matériau électriquement isolant ayant une résistance électrique spécifique supérieure à 10⁹ Ωcm à température ambiante.

7. Dispositif servant à protéger un joint d'étanchéité pour électrode dans un réacteur servant à déposer du silicium polycristallin, dans lequel un corps d'étanchéité (2) est agencé dans un espace intermédiaire entre le porte-électrode (1) de l'électrode et la plaque de fond (3) du réacteur,
et dans lequel une bague de protection (4) entourant radialement le porte-électrode (1) et le corps d'étanchéité (2), qui est en contact avec la plaque de fond,
et un recouvrement (6) entourant radialement le porte-électrode (1) et le corps d'étanchéité (2), qui est en contact avec le porte-électrode (1) et la plaque de fond (3), est prévu, le recouvrement (6) étant en contact avec le porte-électrode aussi bien latéralement que par le haut, et le recouvrement (6) étant constitué par un matériau électriquement isolant ayant une résistance électrique spécifique supérieure à 10⁹ Ωcm à température ambiante, qui présente simultanément une conductivité thermique supérieure à 10 W/mK à température ambiante.

8. Dispositif servant à protéger un joint d'étanchéité pour électrode dans un réacteur servant à déposer du silicium polycristallin, dans lequel un corps d'étanchéité (2) est agencé dans un espace intermédiaire entre le porte-électrode (1) de l'électrode et la plaque de fond (3) du réacteur,
et dans lequel une bague de protection (4) entourant radialement le porte-électrode (1) et le corps d'étanchéité (2), qui est en contact avec la plaque de fond, et des segments annulaires (8) entourant radialement la bague de protection (4) et le porte-électrode (1), sont prévus, la bague de protection (4) étant davantage espacée du porte-électrode (1) que les segments annulaires (8), et aussi bien la bague de protection (4) que les segments annulaires (8) étant constitués par un matériau électriquement isolant ayant une résistance électrique spécifique supérieure à 10⁹ Ωcm à température ambiante, qui présente simultanément une conductivité thermique spécifique supérieure à 1 W/mK à température ambiante.

9. Procédé de fabrication de silicium polycristallin, comprenant l'introduction d'un gaz de réaction contenant un composant contenant du silicium et de l'hydrogène dans un réacteur de dépôt chimique en phase vapeur contenant au moins une baguette filamentaire, qui se trouve sur un dispositif selon l'une quelconque des revendications 1 à 8, qui est alimenté en courant au moyen de l'électrode et ainsi porté par passage de courant direct à une température à laquelle du silicium polycristallin est déposé sur la baguette filamentaire.
